# EUROPÄISCHE PATENTSCHRIFT

(11) **EP 3 548 215 B1**
(45) Veröffentlichungstag und Bekanntmachung des Hinweises auf die Patenterteilung: **10.03.2021**
(21) Anmeldenummer: 17829588.7
(22) Anmeldetag: 24.11.2017
(51) Int. Cl.: B23K 1/00, B23K 37/00, B23K 37/02, B23K 37/04, B23K 37/047, B23K 20/00, B23K 20/10, B23Q 7/14, B65G 17/00, B65G 19/00, H01L 21/02, H01L 21/677, B23K 101/42

(54) **VERFAHREN ZUM BONDEN GROSSER MODULE UND ENTSPRECHENDE BONDANORDNUNG**
METHOD FOR BONDING LARGE MODULES AND CORRESPONDING BONDING ARRANGEMENT
PROCÉDÉ DE SOUDAGE DE MODULES DE GRANDE TAILLE ET SYSTÈME DE SOUDAGE

(30) Priorität: 01.12.2016 DE 102016123294; 05.10.2017 DE 102017123122
(43) Veröffentlichungstag der Anmeldung: 09.10.2019
(73) Patentinhaber: Hesse GmbH, 33104 Paderborn (DE)
(72) Erfinder: WALTHER, Frank, 33100 Paderborn (DE)
(74) Vertreter: Wickord, Wiro
(86) Internationale Anmeldenummer: PCT/DE2017/101020
(87) Internationale Veröffentlichungsnummer: WO 2018/099515

(56) Entgegenhaltungen:
- JP-A- S61 169 412
- US-A- 5 341 563
- US-A1- 2002 025 244
- US-B1- 6 322 659

## Beschreibung

Die Erfindung betrifft ein Verfahren zum Bonden großer Module, siehe Anspruch 1. Ferner betrifft die Erfindung eine Bondanordnung zum Bonden großer Module, siehe Anspruch 5.

Drahtbonder werden zunehmend und insbesondere bei Dickdrahtanwendungen zum Bearbeiten großer Module wie beispielsweise Solarpanel oder Batteriemodule eingesetzt. Zur erfolgreichen Bearbeitung dieser großen Module benötigt der Bonder selbst einen großen Arbeitsbereich, der beispielsweise durch Gantry-Achskinematiken realisiert wird. Eingeschränkt ist der Arbeitsbereich des Gantrys einerseits durch die geforderte Dynamik und die damit verbundene große Maschinensteifigkeit und andererseits durch die Notwendigkeit, dass der Arbeitsbereich für einen Bediener zugänglich sein muss, damit manuelle Eingriffe im gesamten Arbeitsbereich möglich bleiben. Deshalb werden große Module, das heißt Module, die größer sind als der zur Verfügung stehende Arbeitsbereich des Bonders, heute üblicherweise in mehreren Schritten abgearbeitet, wobei diese durch ein zusätzliches Automatisierungssystem (sogenannte Indexersysteme) durch die Maschine geführt werden.

Die Indexersysteme einschließlich der Modulaufnahmen werden hierzu auf die Montageebene des Bonders, welche von der Höhe fest vorgegeben ist, aufgebaut. Durch den Verfahrbereich der vertikalen Achse eines Bondkopfes des Bonders ist die Bearbeitungsebene (gleich Bondhöhe beziehungsweise Bondebene) ebenfalls in einem Bereich vorgegeben, so dass stark unterschiedliche Produkthöhen durch Unterbauten des Indexers und der Produktaufnahme ausgeglichen werden müssen. Diesen Möglichkeiten sind allerdings enge Grenzen gesetzt und die Unterbauten sind nicht flexibel an unterschiedliche Modultypen anpassbar. Zugleich nimmt die Varianz der Module auch in Bezug auf ihre Höhe stark zu, so dass an die Bonder immer größere Anforderungen in Bezug auf die Flexibilität und die Handhabung unterschiedlich hoher Module gestellt werden.

Für eine automatisierte Fertigung der großen Module sind folgende Funktionsschritte notwendig:
- Zuführen des Moduls
- Prozess (Bonden), einschließlich des mehrmaligen Indexens
- Wegführen des Moduls

Für eine unterbrechungsfreie automatisierte Fertigung werden zusätzliche Puffer als Funktionsschritte benötigt:
- Zuführen des Moduls
- Beladepuffer: Vorhalten des Moduls
- Prozess (Bonden), einschließlich des mehrmaligen Indexens
- Entladepuffer: Vorhalten bearbeiteten des Moduls
- Wegführen des Moduls

Diese drei beziehungsweise fünf Prozessschritte sind nach dem Stand der Technik gemeinsam in einer Ebene angeordnet. Damit benötigen diese Lösungen viel Platz, da neben dem eigentlichen Indexersystem weitere Stationen zum Be- und Entladen und zum Puffern außerhalb des Bonders benötigt werden, welche das Zu- und Abführen der Module so organisieren, dass hierdurch der Bonder bei seiner Arbeit nicht negativ beeinflusst wird.

Das Zuführen der großen Module sowie das Wegführen derselben erfolgt üblicherweise an einander gegenüberliegenden Querseiten des Bonders. Über eine erste Querseite werden die Module dem Bonder zugeführt und dann im Arbeitsbereich des Bonders positioniert. Nach dem Bonden werden die Module im Weiteren auf einer der ersten Querseite gegenüberliegenden zweiten Querseite des Bonders aus dem Arbeitsraum herausgeführt und weiter transportiert. Der Platzbedarf seitlich neben dem Bonder ist insofern relativ groß, da zum einen das sequentielle Zuführen des Moduls zum Bondbereich durch das Indexersystem und darüber hinaus der Beladepuffer und der Entladepuffer zu berücksichtigen sind. Zwischen zwei im Fertigungsverlauf benachbarten Bondern ist insofern insbesondere bei den großen Modulen ein vergleichsweise großer Abstand vorzusehen.

Be- und Entladezeiten sowie die notwendigen Indexzeiten derartiger Anordnungen haben eine geringe Performance, Kenngrößen wie zum Beispiel die Anzahl der gefertigten Module je Flächeneinheit je Stunde erreichen nur vergleichsweise kleine Werte.

Aus der US 6 322 659 B1 (Basis für den Oberbegriff der Ansprüche 1 und 5) ist bekannt, große Module über eine Hebeanordnung aus einem Magazin zu entnehmen und an ein Transportsystem zu übergeben. Dem Transportsystem ist dann ein Bonder mit zwei Bondköpfen zur Bearbeitung der großen Module zugeordnet. Die Zuführung der großen Module erfolgt seitlich. In dem Magazin werden die großen Module gestapelt bevorratet.

Eine weitere Bondanordnung, welche zur Bearbeitung großer Module grundsätzlich geeignet ist, wird in der US 5 341 563 A beschrieben. Hier ist ein Hebesystem vorgesehen, über das fertig gebondete Module angehoben und über ein oberhalb der Bondebene vorgesehenes Förderband abtransportiert werden können.

Die US 2002/025244 A1 zeigt die Verwendung einer Hebeanordnung mit einer Transfereinrichtung, die eingerichtet ist, um ein Modul in die Bearbeitungseinrichtung zu führen beziehungsweise das Modul aus der Bearbeitungseinrichtung zu entnehmen. Die Zuführung beziehungsweise Entnahme erfolgt über die gleiche Einrichtung.

Aufgabe der vorliegenden Erfindung ist es insofern, ein verbessertes Verfahren zum Bonden von großen Modulen bereitzustellen. Weiter ist es Aufgabe der Erfindung, eine für das Bonden großer Module ausgebildete Bondanordnung anzugeben.

Zur Lösung der Aufgabe weist die Erfindung die Merkmale des Patentanspruchs 1 auf.

Das erfindungsgemäße Verfahren zum Bonden großer Module sieht insofern die folgenden Schritte vor:
- ein großes Modul wird einem Bonder mittels einer Zuführeinheit in einer Beladeebene von hinten zugeführt;
- das große Modul wird von der Zuführeinheit an eine erste Querfördereinheit übergeben und von ebendieser in eine in dem Bonder vorgesehene erste Pufferposition verbracht, wobei die erste Pufferposition in einer Beladeebene des Bonders vorgesehen ist;
- das große Modul wird in der Beladeebene mittels der ersten Querfördereinheit von der ersten Pufferposition in eine erste Übernahmeposition verbracht und dort an eine Vertikalfördereinheit übergeben;
- mittels der Vertikalfördereinheit wird das große Modul vertikal verfahren und in eine Bondebene verbracht, wobei sich das große Modul in der Bondebene jedenfalls abschnittsweise in einem Arbeitsbereich des Bonders befindet;
- das große Modul wird durch einen ersten Bondkopf und optional zusätzlich durch einen zweiten Bondkopf bearbeitet, wobei an dem Modul elektrisch leitende Bondverbindungen hergestellt werden;
- das große Modul wird von der Vertikalfördereinheit aus der Bondebene vertikal verfahren in eine zweite Übergabeposition und in der zweiten Übergabeposition an eine zweite Querfördereinheit übergeben, wobei die zweite Übergabeposition in einer Entladeebene des Bonders vorgesehen ist;
- von der zweiten Querfördereinheit wird das große Modul in der Entladeebene in eine zweite Pufferposition verbracht;
- von der zweiten Pufferposition wird das große Modul mittels der zweiten Querfördereinheit an eine Wegführeinheit übergeben.

Der besondere Vorteil der Erfindung besteht darin, dass die Module dem Bonder in einer ersten Ebene, der Beladeebene, zugeführt werden und in einer getrennten zweiten Ebene, der Entladeebene, abtransportiert werden. Darüber hinaus erfolgt die Zuführung sowie das Abfördern von hinten beziehungsweise nach hinten mit der Folge, dass zueinander benachbarte Bonder einen sehr geringen Abstand zueinander aufweisen müssen und im Extremfall unmittelbar benachbart zueinander angeordnet werden können. Einander zugewandte Querseiten der benachbarten Bonder können einander insofern berühren beziehungsweise die benachbarten Bonder können miteinander verbunden werden. Der Flächenbedarf kann hierdurch signifikant reduziert werden. Darüber hinaus erhöht sich der Durchsatz, da in zwei beziehungsweise drei Ebenen gleichzeitig gearbeitet werden kann.

Insbesondere gelingt es nach der Erfindung, die erste Pufferposition (Beladepuffer) für das große Modul und die zweite Pufferposition (Entladepuffer) für das große Modul in den Bonder zu integrieren und in unterschiedlichen Ebenen anzuordnen. Die Module sind insofern in dem Bonder unmittelbar geschützt und platzsparend in zwei Ebenen vorgesehen.

Im Sinne der Erfindung wird ein Modul dem Bonder von hinten zugeführt beziehungsweise nach hinten an die Wegführeinheit übergeben, wenn an einem Maschinengehäuse des Bonders auf einer Rückseite desselben eine Ausnehmung gebildet ist zum Durchführen des Moduls beziehungsweise wenn die Rückseite des Bonders ausgespart ist. Die Rückseite des Bonders ist hierbei definiert als eine einer Bedienfront beziehungsweise Frontseite gegenüberliegenden Seite. Die Frontseite ist ausgebildet, um einem Bediener Zugang zu dem Bonder zu verschaffen. Im Bereich der Frontseite sind etwaige Monitore und Bedienelemente angeordnet und über die Frontseite ist der Arbeitsbereich für den Bediener zugänglich. Die erste Querseite und die zweite Querseite verbinden die Frontseite und die Rückseite des Bonders.

Nach einer bevorzugten Ausführungsform der Erfindung weist die Vertikalfördereinheit einen zur Aufnahme des Moduls ausgebildeten, vertikal verfahrbaren Tragekörper auf. Der Tragekörper ist beim Verbringen des Moduls aus der ersten Pufferposition in die erste Übergangsposition unter der Beladeebene abgesenkt vorgesehen. Vorteilhaft kann in der abgesenkten Position des Tragekörpers das Modul mittels der ersten Querfördereinheit kollisionsfrei von der ersten Pufferposition in die erste Übergangsposition verbracht und dort von dem Tragekörper der Vertikalfördereinheit aufgenommen werden, sobald dieser vertikal nach oben verfahren wird.

Nach einer Weiterbildung der Erfindung wird die zweite Übergabeposition für das Modul überfahren beim Verbringen desselben von der ersten Übergabeposition in die Bondebene. Vorteilhaft ergeben sich durch die Anordnung der zweiten Übergabeposition im Verfahrweg der Vertikalfördereinheit ein sehr kompakter Aufbau für den Bonder und ein geringer Platzbedarf.

Nach einer Weiterbildung der Erfindung wird der Tragekörper aus der Bondebene vertikal verfahren und unter die Beladeebene abgesenkt, wobei beim Absenken des Tragekörpers das Modul an die zweite Querfördereinheit übergeben wird, während die zweite Übergabeposition überfahren wird. Vorteilhaft ergeben sich durch die Übergabe des Moduls an die zweite Querfördereinheit während des Absenkens des Tragekörpers eine sehr geringe Zykluszeit und ein hoher Durchsatz für das erfindungsgemäße Bondverfahren. Pro Zeiteinheit können insofern viele Module gefertigt werden.

Zur Lösung der Aufgabe weist die Erfindung die Merkmale des Patentanspruchs 5 auf.

Die erfindungsgemäße Bondanordnung mit einem Bonder, mit einer Zuführeinheit für ein großes Modul, welches mittels des Bonders bearbeitbar und mit einer Wegführeinheit für das große Module umfasst insofern die folgenden Merkmale:
- der Bonder umfasst wenigstens einen Bondkopf, mittels dem bei der Bearbeitung des großem Moduls elektrisch leitenden Bondverbindungen an dem großen Modul herstellbar sind;
- der Bonder umfasst weiter eine Vertikalfördereinheit, welche ausgebildet ist um vertikalen Fördern des großen Moduls aus einer Beladeebene in eine Bondebene und/oder in eine Entladeebene;
- der Bonder umfasst weiter eine erste Querfördereinheit, welche der Beladeebene zugeordnet ist und ausgebildet ist zum Aufnehmen des großen Moduls von der Zuführeinheit, zum Verbringen des Moduls in eine in der Beladeebene vorgesehen erste Pufferposition und zum Verbringen des großen Moduls eine erste Übergabeposition, in der das große Modul für die Übergabe an die Vertikalfördereinheit bereitgestellt ist;
- der Bonder umfasst bevorzugt eine zweite Querfördereinheit, welche der Entladeebene zugeordnet ist und ausgebildet ist zum Übernehmen des großen Moduls von der Vertikalfördereinheit in einer zweiten Übergabeposition, zum Verbringen des großen Moduls in eine zweite Pufferposition, wobei die zweite Übergabeposition und die zweite Pufferposition in der Entladeebene vorgesehen sind, und zum Übergeben des großen Modul an die ebenfalls der Entladeebene zugeordnete Wegführeinheit.

Der besondere Vorteil der Erfindung besteht darin, dass eine sehr kompakte Bondanordnung bereitgestellt ist, bei der die Module in dem Bonder selbst platzsparend bevorratet beziehungsweise gepuffert werden und bei der das Zuführen und Abführen der Module in zwei getrennten Ebenen angeordnet ist. Der Platzbedarf für die erfindungsgemäße Bondanordnung ist insofern gering und es kann pro Flächeneinheit eine höhere Bondleistung erbracht werden. Insbesondere für Applikationen, bei denen der Bonder vor Umwelteinflüssen geschützt beispielsweise in einer reinen Raumumgebung vorgesehen ist, ergeben sich hierdurch erhebliche Kostenvorteile.

Beispielsweise kann die Bondebene oberhalb der Beladeebene und oberhalb der Entladeebene vorgesehen sein. Beispielsweise kann die Entladeebene oberhalb der Beladeebene vorgesehen sein. Die Entladeebene liegt insofern zwischen der Bondebene und der Beladeebene. Beispielsweise kann die erste Pufferposition zwischen der Zuführeinheit einerseits und der ersten Übergabeposition andererseits vorgesehen sein. In analoger Weise kann die zweite Pufferposition zwischen der Wegführeinheit einerseits und der zweiten Übergabeposition andererseits vorgesehen sein. Die erste Pufferposition und/oder die zweite Pufferposition und/oder die erste Übergabeposition und/oder die zweite Übergabeposition können in einem Maschinengehäuse des Bonders vorgesehen sein. Vorteilhaft ergibt sich hierdurch ein sehr kompakter Aufbau und die Module können von dem Maschinengehäuse umgeben geschützt in dem Bonder gepuffert und bereitgestellt werden. Indem auf eine Pufferung auf der Zuführeinheit beziehungsweise der Wegführeinheit verzichtet wird, können die Zuführeinheit und die Wegführeinheit eine hohe Förderleistung aufweisen und der Versorgung von einer Mehrzahl von Bondern dienen. Stillstandzeiten im Bereich der Zuführeinheit beziehungsweise der Wegführeinheit werden vermieden beziehungsweise reduziert.

Nach einer Weiterbildung der Erfindung sind die Zuführeinheit und die Wegführeinheit dem Bonder auf einer Rückseite desselben zugeordnet und insbesondere höhenversetzt übereinander angeordnet, wobei die Wegführeinheit der Entladeebene und der Zuführeinheit der Beladeebene zugeordnet sind. Vorteilhaft reduziert sich hierdurch der Platzbedarf weiter und die Anzahl der gefertigten Module je Zeit- und Flächeneinheit steigt.

Nach einer Weiterbildung der Erfindung weist die Vertikalfördereinheit eine vertikal erstreckte Führungsschiene und eine an der Führungsschiene verschiebbar gehaltenen Tragekörper auf. Vorteilhaft ergibt sich hierdurch eine kostengünstige Realisierung für die Vertikalfördereinheit und eine zugleich präzise Möglichkeit zum Positionieren des Tragekörpers einerseits beziehungsweise des mittels des Tragekörpers bereitgestellten Moduls andererseits in der ersten Übergabeposition und/oder in der zweiten Übergabeposition und/oder in der Bondebene.

Nach einer Weiterbildung der Erfindung weisen die erste Querfördereinheit und/oder die zweite Querfördereinheit je einen Schlitten auf, welcher horizontal verschiebbar gehalten ist und von der ersten Pufferposition in die erste Übergabeposition beziehungsweise von der zweiten Pufferposition in die zweite Übergabeposition und zurück verbringbar ist. Der Schlitten ist insofern in der Beladeebene (erste Querfördereinheit) beziehungsweise in der Entladeebene (zweite Querfördereinheit) verschiebbar. Die erste Querfördereinheit ist unabhängig von der zweiten Querfördereinheit bewegbar. Zudem sind die erste Querfördereinheit und die zweite Querfördereinheit unabhängig von der Vertikalfördereinheit verschiebbar. Ungeachtet der unabhängigen Bewegungsmöglichkeit erfolgt die Bewegung der ersten Querfördereinheit und der zweiten Querfördereinheit sowie der Vertikalfördereinheit verfahrensseitig in gekoppelter beziehungsweise koordinierter Form so, dass ein hoher Durchsatz an Modulen realisiert, Stillstandzeiten vermieden und eine Kollision der Einheiten beziehungsweise Module verhindert werden.

Sofern die Entladeebene sich zwischen der Beladeebene und der Bondebene befindet, befindet sich der Schlitten der der Entladeebene zugeordneten zweiten Querfördereinheit beim Verfahren der Vertikalfördereinheit aus der Beladeebene in die Bondebene derart außer Eingriff in der zugeordneten Pufferposition oder benachbart hierzu, dass die Entladeebene kollisionsfrei durchfahren werden kann. Analog gilt, dass der der Beladeebene zugeordnete Schlitten außerhalb des Verfahrbereichs der Vertikalfördereinheit verbracht ist, sofern die Beladeebene sich zwischen der Entladeebene und der Bondebene befindet und das Modul mit der Vertikalfördereinheit von der Bondebene in die Entladeebene verbracht wird.

Nach einer Weiterbildung der Erfindung sieht der Bonder eine Andrückplatte für das Modul vor, gegen die das Modul in der Bondebene von der Vertikalfördereinheit von unten angedrückt ist. Das Modul befindet sich insofern in einer stets gleichen und bekannten Position. Die Andrückplatte kann modulspezifisch austauschbar gestaltet sein.

Gegenüber den bisherigen Bonderkonzepten auf dem Markt zeichnet sich die Erfindung unter Beibehaltung des Gantry-Achssystems des Bonders insofern beispielsweise durch folgende Merkmale aus:
- Ersatz der festen Montageebene durch ein Liftsystem, welches zum einen die Übernahme der großen Module gewährleistet und zum anderen das große Modul von unten an eine in der Bearbeitungsebene vorhandene Andruckplatte klemmt. Die Bearbeitungsebene ist damit unabhängig von der Modulhöhe immer gleich. Die Andruckplatte ist modulspezifisch austauschbar.
- Die großen Module werden direkt im Arbeitsbereich des Bonders mittels einer Vertikalfördereinheit vertikal nach unten und oben gefahren und dabei die Be- und Entladeebene sowie die Bondebene erreicht.
- Integration des Be- und Entladens durch zwei Querfördereinheiten innerhalb der Maschine in zwei unterschiedlichen Ebenen.
- Die Module werden nicht mehr durch den Bonder hindurchgeführt, das heißt von einer ersten (Quer-)Seite zugeführt und zu einer zweiten, gegenüberliegenden (Quer-)Seite abgeführt. Vielmehr erfolgen die Zuführung und die Abführung über die gleiche Seite des Maschinengehäuses.
- Die Zu- und Abführung der großen Module erfolgt von hinten (Rückseite) statt von der Querseite. Damit lassen sich die Maschinen schmal bauen und optimal verketten.
- Der Platz unterhalb der Bondebene wird optimal verwendet. Die vertikale Stellbewegung für das Modul ist mit Ausnahme einer geringen Hubbewegung zum Klemmen des Moduls bei heutigen Bondanordnungen unbekannt und nicht für die Handhabung des Moduls genutzt.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Erfindungsgemäß beschriebene Merkmale und Details des Verfahrens gelten selbstverständlich auch im Zusammenhang mit der erfindungsgemäßen Bondanordnung und umgekehrt. So kann auf die Offenbarung zu den einzelnen Erfindungsaspekten stets wechselseitig Bezug genommen werden. Die Zeichnungen dienen lediglich beispielhaft der Klarstellung der Erfindung und haben keinen einschränkenden Charakter.

Es zeigen:
- Fig. 1: eine erfindungsgemäße Bondanordnung mit einer Mehrzahl von einander benachbart zugeordneten Bondern in einer perspektivischen Vorderseitenansicht,
- Fig. 2: die Bondanordnung nach Fig. 1 in einer perspektivischen Rückseitenansicht,
- Fig. 3: eine erste alternative Ausgestaltung eines Bonders der erfindungsgemäßen Bondanordnung nach Fig. 1 in einer Einzelansicht,
- Fig. 4: eine zweite alternative Ausgestaltung eines Bonders der erfindungsgemäßen Bondanordnung nach Fig. 1 in einer Einzelansicht,
- Fig. 5: eine dritte alternative Ausgestaltung eines Bonders der erfindungsgemäßen Bondanordnung nach Fig. 1 in einer Einzelansicht,
- Fig. 6: eine Prinzipdarstellung der erfindungsgemäßen Bondanordnung in einer Seitenansicht,
- Fig. 7: einen ersten Verfahrensschritt beim Bereitstellen eines Moduls für den Bonder,
- Fig. 8: einen zweiten Verfahrensschritt beim Bereitstellen eines Moduls für den Bonder,
- Fig. 9: einen dritten Verfahrensschritt beim Bereitstellen eines Moduls für den Bonder,
- Fig. 10: einen vierten Verfahrensschritt beim Bereitstellen eines Moduls für den Bonder,
- Fig. 11: einen fünften Verfahrensschritt beim Bereitstellen eines Moduls für den Bonder und
- Fig. 12: einen sechsten Verfahrensschritt beim Bereitstellen eines Moduls für den Bonder.

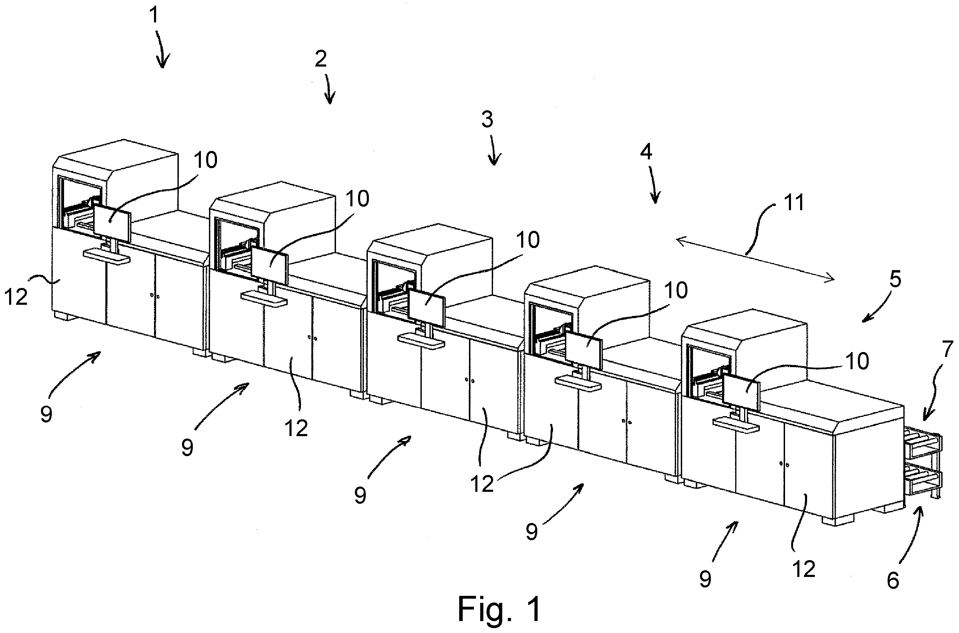

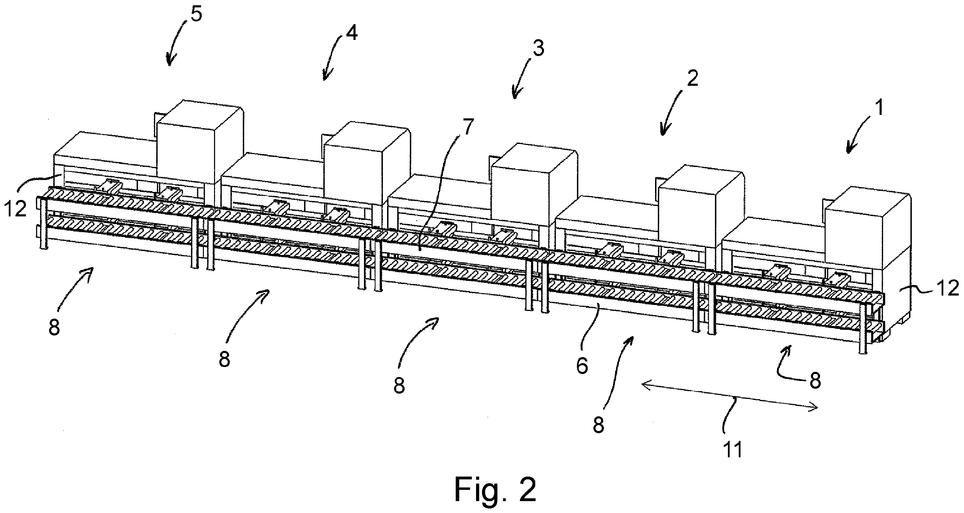

Eine erfindungsgemäße Bondanordnung nach den Fig. 1 und 2 umfasst exemplarisch fünf baugleiche Bonder 1, 2, 3, 4, 5 sowie eine gemeinsame Zuführeinheit 6 und eine ebenfalls gemeinsame Wegführeinheit 7. Die Bonder 1, 2, 3, 4, 5 sind einander benachbart zugeordnet, wobei einander zugewandte Querseiten der Bonder 1, 2, 3, 4, 5 aneinander anliegen. Die Zuführeinheit 6 und die Wegführeinheit 7 sind den Bondern 1, 2, 3, 4, 5 auf einer Rückseite 8 derselben zugeordnet. Der Rückseite 8 gegenüberliegend weisen die Bonder 1, 2, 3, 4, 5 eine Frontseite 9 auf, welche ausgebildet ist zum Bedienen der Bonder 1, 2, 3, 4, 5 durch einen Bediener. Im Bereich der Frontseite 9 sind die Bonder 1, 2, 3, 4, 5 zugänglich. Darüber hinaus sind Bedienelemente für die Bonder 1, 2, 3, 4, 5 im Bereich der Frontseite angeordnet. Ebenfalls ist ein Arbeitsbereich des Bonders 1, 2, 3, 4, 5 über die Frontseite 9 zugänglich und für jeden Bonder 1, 2, 3, 4, 5 ein Bedienmonitor 10 der Frontseite 9 zugeordnet. Zwei einander gegenüberliegende Querseiten verbinden die Rückseite 8 und die Frontseite 9.

Die Zuführeinheit 6 sowie die Wegführeinheit 7 sind vorliegend als Rollenförderer ausgebildet und in einer Transportrichtung 11 längs erstreckt angeordnet. Die Wegführeinheit 7 ist oberhalb der Zuführeinheit 6 vorgesehen. Die mittels der Zuführeinheit 6 zugeführten beziehungsweise mittels der Wegführeinheit 7 weggeführten Module, die in den Fig. 1 und 2 sowie 6 nicht dargestellt sind, werden über eine Ausnehmung, welche im Bereich der Rückseite 8 an einem Maschinengehäuse 12 der Bonder 1, 2, 3, 4, 5 vorgesehen ist, zugeführt. Die Transportrichtung erstreckt sich parallel zur Rückseite 8.

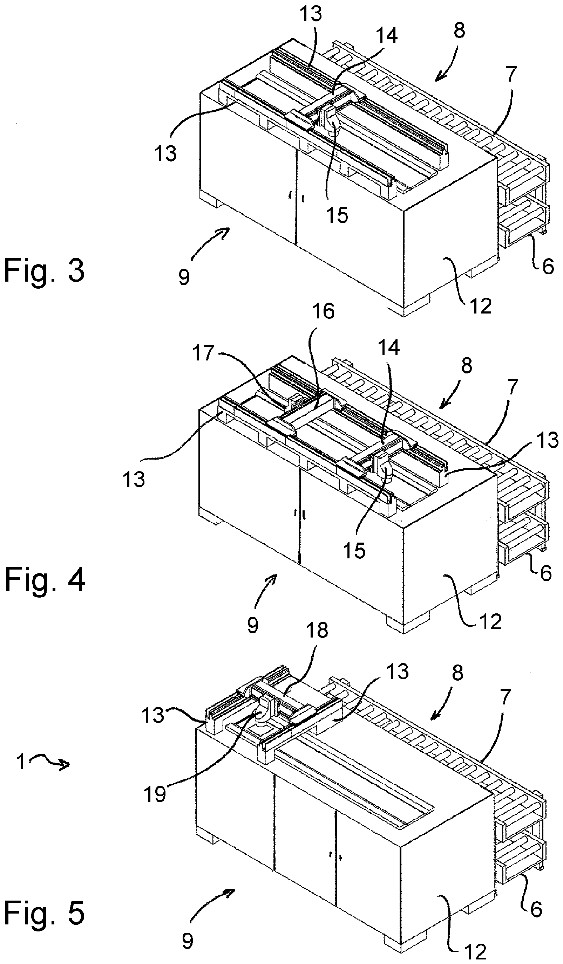

Innerhalb der erfindungsgemäßen Bondanordnung können beispielsweise verschiedenartige Bonder 1, 2, 3, 4, 5 vorgesehen werden. Die Fig. 3 bis 5 zeigen insofern alternative Ausführungsformen der Bonder 1, 2, 3, 4, 5, wobei die erfindungswesentlichen Aspekte allein exemplarisch für einen ersten Bonder 1 erläutert sind.

Gemäß Fig. 3 sieht der erste Bonder 1 eine sich im Wesentlichen über die gesamte Länge des Bonders 1 erstreckende Parallelführung 13 mit einer an der Parallelführung 13 längs verschiebbar gehaltenen Quertraverse 14 und einem Bondkopf 15 vor, welcher an der Quertraverse 14 festgelegt und dort querverschiebbar gehalten ist. Der Bondkopf 15 kann insofern über das Verfahren desselben an der Quertraverse 14 sowie das Verfahren der Quertraverse 14 über die Parallelführung 13 einen vergleichsweise großen Arbeitsraum abdecken.

Fig. 4 zeigt eine alternative Ausgestaltung des Bonders 1, wobei die Parallelführung 13 übernommen ist und an der Parallelführung 13 zwei Quertraversen 14, 16 mit jeweils einem Bondkopf 15, 17 vorgesehen sind. Der Arbeitsraum des Bonders 1 nach Fig. 4 entspricht dem des Bonders 1 nach Fig. 3. Jedoch kann gleichzeitig mit zwei Bondköpfen 15, 17 gearbeitet werden.

Gemäß Fig. 5 sind die Parallelführungen 13 quer erstreckt und an den Parallelführungen 13 ist eine Längstraverse 18 mit einem Bondkopf 19 vorgesehen. Die Lage und Anordnung der Parallelführungen 13 ist insbesondere so gewählt, dass der Arbeitsbereich des Bonders 1 gemäß Fig. 5 kleiner ist als der Arbeitsbereich für die Bonder 1 gemäß der Fig. 3 und 4.

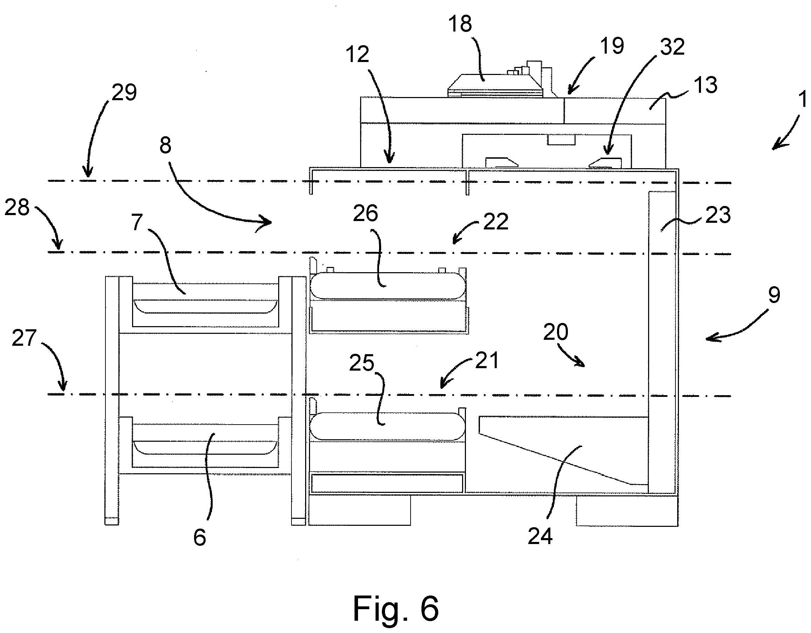

Fig. 6 zeigt eine Prinzipdarstellung der erfindungsgemäßen Bondanordnung in einem Querschnitt. Neben dem Bonder 1 sind die Zuführeinheit 6 sowie die Wegführeinheit 7 vorgesehen, welche übereinander beabstandet zu der Rückseite 8 des Bonders 1 angeordnet sind. Die großen Module, die zu bonden sind, sind aus Gründen der Übersichtlichkeit nicht dargestellt.

Der Bonder 1 umfasst das Maschinengehäuse 12. In dem Maschinengehäuse 12 sind eine Vertikalfördereinheit 20, eine erste Querfördereinheit 21 und eine zweite Querfördereinheit 22 vorgesehen. Die Vertikalfördereinheit 20 umfasst eine vertikal erstreckte Führungsschiene 23 sowie einen Tragekörper 24, welcher an der vertikal orientierten Führungsschiene 23 verschiebbar gehalten ist. Die erste Querfördereinheit 21 sieht einen horizontal verschiebbar gehaltenen Schlitten 25 vor, welcher vorliegend in einer ersten Pufferposition unterhalb der zweiten Querfördereinheit 22 angeordnet ist. Aus der ersten Pufferposition kann der Schlitten 25 horizontal in Richtung der Vertikalfördereinheit 20 verschoben werden und in eine erste Übergabeposition gelangen, in der ein Modul von der ersten Querfördereinheit 21 an die Vertikalfördereinheit 20 übergeben wird.

In analoger Weise sieht die zweite Querfördereinheit 22 einen Schlitten 26 vor, der wie der Schlitten 25 der ersten Querfördereinheit 21 horizontal verschiebbar vorgesehen ist. Der Schlitten 26 ist in einer zweiten Pufferposition positioniert. Aus der zweiten Pufferposition kann aus dieser horizontal in Richtung der Vertikalfördereinheit 20 in eine zweite Übergabeposition verschoben werden.

Die Zuführeinheit 6 definiert zusammen mit der Querfördereinheit 21 eine Beladeebene 27 des Bonders 1, welche unter einer Entladeebene 28 und einer Bondebene 29 vorgesehen ist. Die Entladeebene 28 ist zwischen der Beladeebene 27 und der Bondebene 29 vorgesehen und durch die Wegführeinheit 7 sowie die zweite Querfördereinheit 22 definiert. Oberhalb der Entladeebene 28 findet sich die Bondebene 29, in der ein zu bearbeitendes großes Modul während der Bearbeitung vorgesehen ist.

Der Tragekörper 24 der Vertikalfördereinheit 20 kann entlang der Führungsschiene 23 so verfahren werden, dass das große Modul in der Bondebene 29 positioniert werden kann. Darüber hinaus kann der Tragekörper 24 bis unter die Beladeebene 27 abgesenkt werden.

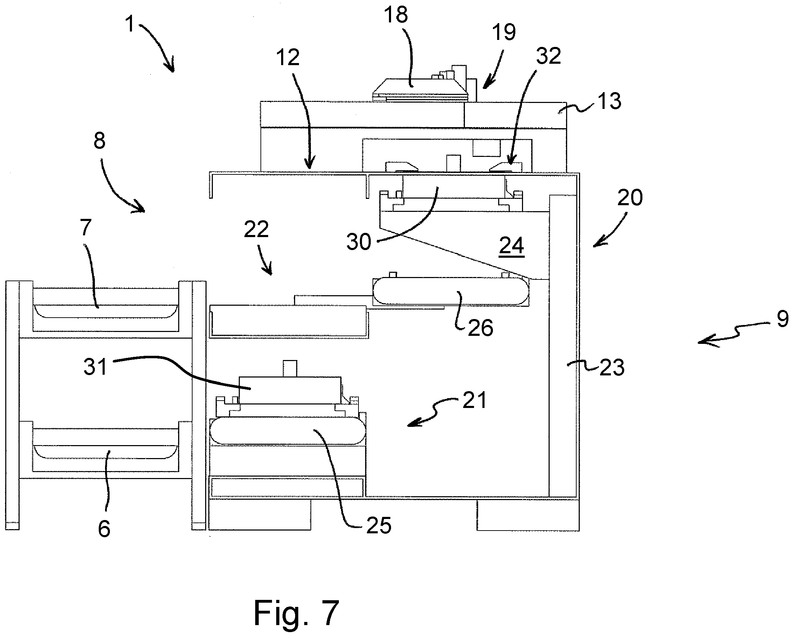

Das erfindungsgemäße Verfahren sowie die Details der erfindungsgemäßen Bondanordnung werden nachfolgend anhand der Fig. 7 bis 12 dargestellt. Es wird hierzu in einer Ausgangskonfiguration nach Fig. 7 ein erstes Modul 30 von dem Tragekörper 24 der Vertikalfördereinheit 20 in der Bondebene 29 gehalten. Das erste Modul 30 ist im Vorfeld über die Zuführeinheit 6 zugeführt worden. Ein zweites Modul 31 ist zugleich in einer ersten Pufferposition von der Querfördereinheit 21 bereitgestellt. Der Schlitten 26 der zweiten Querfördereinheit 22 befindet sich in der zweiten Übergabeposition unterhalb des Tragekörpers 24.

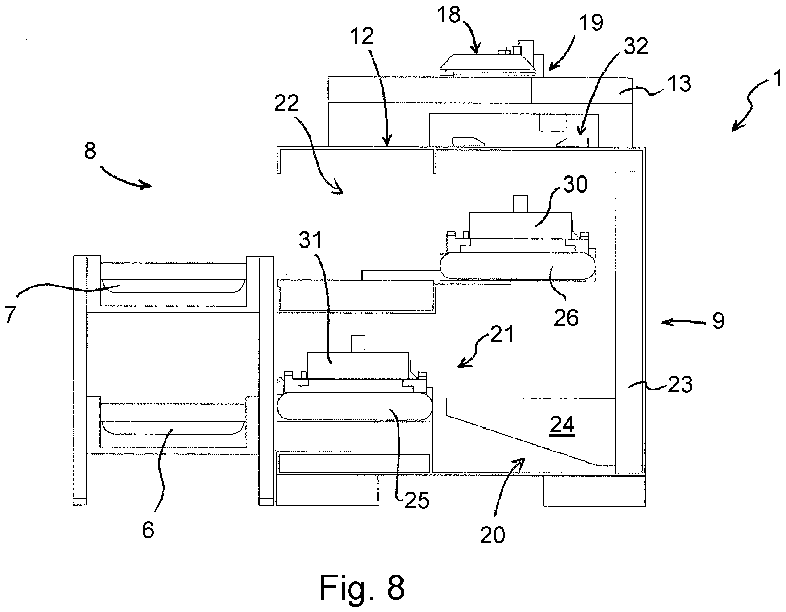

Um nunmehr das zweite Modul 31 zu bonden, wird der Tragekörper 24 entlang der Führungsschiene 23 unter die Beladeebene 27 abgesenkt. Dabei wird das erste Modul 30, welches im vorherigen Verfahrensschritt gebondet wurde, auf dem Schlitten 26 der zweiten Querfördereinheit 27 abgesetzt, während die zweite Übergabeposition von dem Tragekörper 24 überfahren wird, vergleiche Fig. 8.

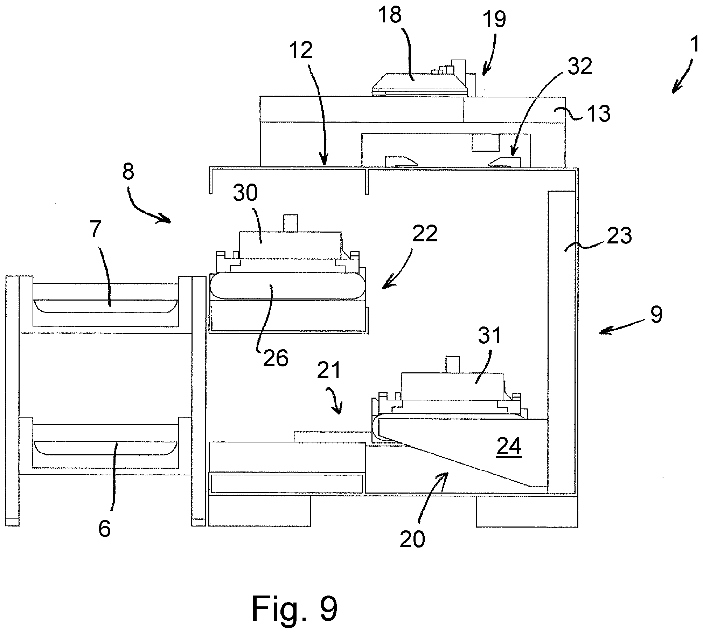

Im nächsten Verfahrensschritt gemäß Fig. 9 wird der Schlitten 25 der ersten Querfördereinheit 21 von der ersten Pufferposition in die erste Übergabeposition verbracht, sodass das zweite Modul 31 oberhalb des Tragekörpers 24 der Führungsschiene 23 vorgesehen ist. Ebenfalls wird der Schlitten 26 der zweiten Querfördereinheit 22 in die zweite Pufferposition verbracht.

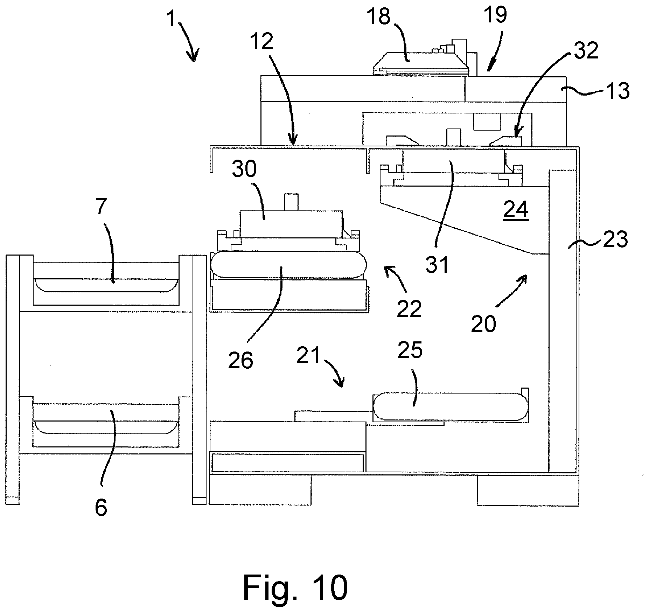

Im Weiteren wird das zweite Modul 31 vom Tragekörper 24 vertikal angehoben und in die Bondebene 29 verbracht. Dort wird das zweite Modul 31 gegen eine Andrückplatte 32 des Bonders 1 von unten angedrückt und so höhenmäßig positioniert. Mittels des Bondkopfes 15 werden dann die elektrisch leitenden Bondverbindungen an dem ersten Modul 30 ausgebildet, vergleiche Fig. 10.

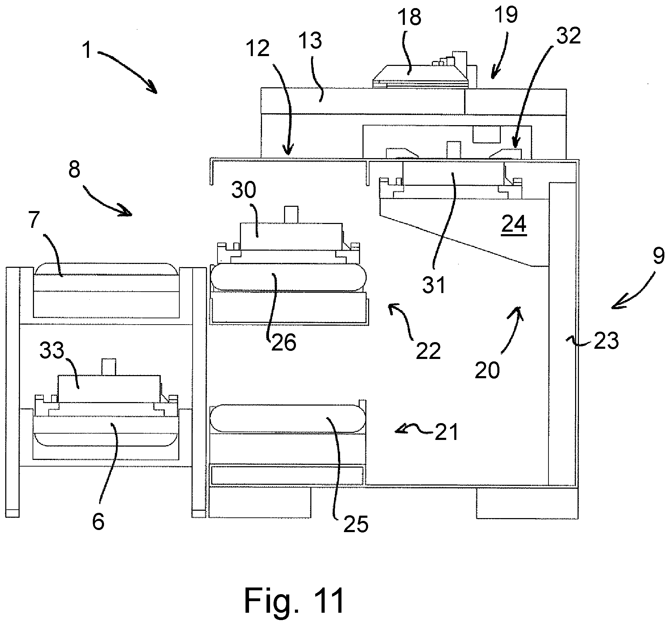

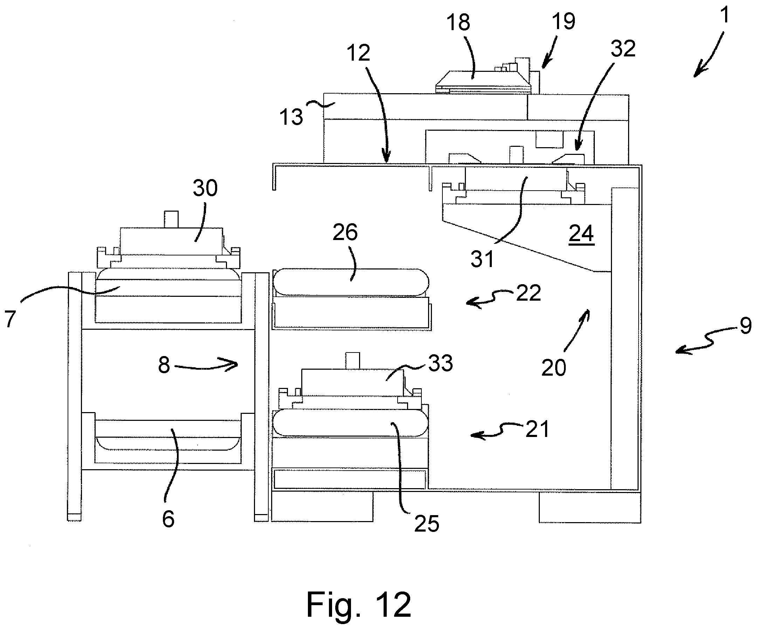

Gemäß Fig. 11 wird im nächsten Schritt mittels der Zuführeinheit 6 ein drittes Bondmodul 33 bereitgestellt. Im Anschluss wird das dritte Modul 33 von der Zuführeinheit 6 in die erste Pufferposition verbracht und das zweite Modul 31 von der zweiten Pufferposition an die Wegführeinheit 7 übergeben, vergleiche Fig. 12. Der Verfahrenszyklus kann dann von Neuem durchgeführt und das erste Bondmodul 30 von der Wegführeinheit 7 abtransportiert werden.

Die Erfindung ist nicht auf die dargestellte Ausführungsform der Bondanordnung sowie das anhand der Figuren diskutierte Verfahren beschränkt.

Beispielsweise kann vorgesehen sein, dass die Zuführeinheit 6 und die Wegführeinheit 7 für die Module 30, 31, 33 integriert realisiert sind. Insofern kann ein einziger Rollenförderer oder eine andere geeignete Transportvorrichtung zugleich als Zuführeinheit 6 und als Wegführeinheit 7 dienen. Die Beladeebene 27 und die Entladeebene 28 fallen dann zusammen.

Beispielsweise können die Module 30, 31, 33 mittels der ersten Querfördereinheit 21 von der Zuführeinheit 6 übernommen und in das Maschinengehäuse 12 des Bonders 1 gefahren werden. Hierzu kann beispielsweise der Schlitten 25 der ersten Querfördereinheit 21 dienen. Beispielsweise kann vorgesehen sein, dass an der Zuführeinheit 6 geeignete Mittel zum Anheben der Module 30, 31, 33 vorgesehen sind. Beispielsweise können die Zuführeinheit 6 und/oder die erste Querfördereinheit 21 über separate Handhabungsmittel zum Verbringen der Module 30, 31, 33 in die erste Pufferposition verfügen. In analoger Weise kann die Übergabe der Module 30, 31, 33 an die Wegführeinheit 7 erfolgen. Es können insofern geeignete Handhabungsmittel als Teil der Wegführeinheit 7 vorgesehen sein und/oder die Module 30, 31, 33 von der zweiten Querfördereinheit 22 an die Wegführeinheit 7 übergeben werden.

Innerhalb der erfindungsgemäßen Bondanordnung können stets gleichartige Bonder 1, 2, 3, 4, 5 vorgesehen sein oder Bonder 1, 2, 3, 4, 5 in unterschiedlicher Ausgestaltung. Die Bonder 1, 2, 3, 4, 5 können optional seitlich beabstandet zueinander vorgesehen sein. Die flächige Anlage der Querseiten der Bonder 1, 2, 3, 4, 5 ist insofern lediglich exemplarisch gewählt.

Gleiche Bauteile und Bauteilfunktionen sowie Komponenten sind durch gleiche Bezugszeichen gekennzeichnet.

## Patentansprüche

1. Verfahren zum Bonden großer Module (30, 31, 33) **gekennzeichnet durch** folgende Schritte:
- ein großes Modul (30, 31, 33) wird einem Bonder (1, 2, 3, 4, 5) mittels einer Zuführeinheit (6) in einer Beladeebene (27) von hinten zugeführt;
- das große Modul (30, 31, 33) wird von der Zuführeinheit an eine erste Querfördereinheit (21) übergeben und von ebendieser in eine in dem Bonder (1, 2, 3, 4, 5) vorgesehene erste Pufferposition verbracht, wobei die erste Pufferposition in einer Beladeebene (27) des Bonders (1, 2, 3, 4, 5) vorgesehen ist;
- das große Modul (30, 31, 33) wird in der Beladeebene (27) mittels der ersten Querfördereinheit (21) von der ersten Pufferposition in eine erste Übernahmeposition verbracht und dort an eine Vertikalfördereinheit (20) übergeben;
- mittels der Vertikalfördereinheit (20) wird das große Modul (30, 31, 33) vertikal verfahren und in eine Bondebene (29) verbracht, wobei sich das große Modul (30, 31, 33) in der Bondebene (29) jedenfalls abschnittsweise in einem Arbeitsbereich des Bonders (1, 2, 3, 4, 5) befindet;
- das große Modul (30, 31, 33) wird durch einen ersten Bondkopf (15, 19) und optional zusätzlich durch einen zweiten Bondkopf (15, 19) bearbeitet, wobei an dem Modul (30, 31, 33) elektrisch leitende Bondverbindungen hergestellt werden;
- das große Modul (30, 31, 33) wird von der Vertikalfördereinheit (20) aus der Bondebene (29) vertikal verfahren in eine zweite Übergabeposition und in der zweiten Übergabeposition an eine zweite Querfördereinheit (22) übergeben, wobei die zweite Übergabeposition in einer Entladeebene (28) des Bonders (1, 2, 3, 4, 5) vorgesehen ist;
- von der zweiten Querfördereinheit (22) wird das große Modul (30, 31, 33) in der Entladeebene (28) in eine zweite Pufferposition verbracht;
- von der zweiten Pufferposition wird das große Modul (30, 31, 33) mittels der zweiten Querfördereinheit (22) an eine Wegführeinheit (7) übergeben.

2. Verfahren nach Anspruch 1, **dadurch gekennzeichnet, dass** die Vertikalfördereinheit (20) einen zur Aufnahme des Moduls (30, 31, 33) ausgebildeten, vertikal verschiebbaren Tragekörper (24) aufweist, wobei der Tragekörper (24) vor der Verbringung des Moduls (30, 31, 33) von der ersten Pufferposition in die Übergabeposition unter die Beladeebene (27) abgesenkt wird.

3. Verfahren nach Anspruch 1 oder 2, **dadurch gekennzeichnet, dass** beim Verbringen des Moduls (30, 31, 33) von der ersten Übergabeposition in die Bondebene (29) die zweite Übergabeposition für das Modul (30, 31, 33) überfahren wird und/oder die zweite Querfördereinheit (22) in der zweiten Pufferposition vorgesehen ist.

4. Verfahren nach einem der Ansprüche 1 bis 3, **dadurch gekennzeichnet, dass** der Tragekörper (24) aus der Bondebene (29) vertikal verfahren und unter die Beladeebene (27) abgesenkt wird und dass bei diesem Absenken des Tragekörpers (24) das Modul (30, 31, 33) an die zweite Querfördereinheit (22) übergeben wird, während die zweite Übergabeposition überfahren wird.

5. Bondanordnung mit einem Bonder (1, 2, 3, 4, 5), mit einer Zuführeinheit (6) für ein großes Modul (30, 31, 33), welches mittels des Bonders (1, 2, 3, 4, 5) bearbeitbar ist, und mit einer Wegführeinheit (7) für das große Modul (30, 31, 33), wobei der Bonder (1, 2, 3, 4, 5) wenigstens einen Bondkopf (15, 17, 19) umfasst, mittels dessen bei der Bearbeitung des großen Moduls (30, 31, 33) elektrisch leitende Bondverbindungen an dem großen Modul (30, 31, 33) herstellbar sind, **gekennzeichnet durch** die folgenden Merkmale:
- der Bonder (1, 2, 3, 4, 5) umfasst eine Vertikalfördereinheit (20), welche ausgebildet ist zum vertikalen Fördern des großen Moduls (30, 31, 33) aus einer Beladeebene (27) in eine Bondebene (29) und/oder in eine Entladeebene (28);
- der Bonder (1, 2, 3, 4, 5) umfasst weiter eine erste Querfördereinheit (21), welche der Beladeebene (27) zugeordnet ist und ausgebildet ist zum Aufnehmen des großen Moduls (30, 31, 33) von der Zuführeinheit (6), zum Verbringen des Moduls (30, 31, 33) in eine in der Beladeebene (27) vorgesehene erste Pufferposition und zum Verbringen des großen Moduls (30, 31, 33) in eine erste Übergabeposition, in der das große Modul (30, 31, 33) für die Übergabe an die Vertikalfördereinheit (20) bereitgestellt ist;
- der Bonder (1, 2, 3, 4, 5) umfasst bevorzugt eine zweite Querfördereinheit (22), welche der Entladeebene (28) zugeordnet ist und ausgebildet ist zum Übernehmen des großen Moduls (30, 31, 33) von der Vertikalfördereinheit (20) in einer zweiten Übergabeposition, zum Verbringen des großen Moduls (30, 31, 33) in eine zweite Pufferposition, wobei die zweite Übergabeposition und die zweite Pufferposition in der Entladeebene (28) vorgesehen sind, und zum Übergeben des großen Moduls (30, 31, 33) an die ebenfalls der Entladeebene (28) zugeordnete Wegführeinheit (7).

6. Bondanordnung nach Anspruch 5, **dadurch gekennzeichnet, dass** die Bondebene (29) oberhalb der Beladeebene (27) und/oder oberhalb der Entladeebene (28) vorgesehen ist.

7. Bondanordnung nach Anspruch 5 oder 6, **dadurch gekennzeichnet, dass** die Entladeebene (28) oberhalb der Beladeebene (27) vorgesehen ist.

8. Bondanordnung nach einem der Ansprüche 5 bis 7, **dadurch gekennzeichnet, dass** die erste Pufferposition und/oder die zweite Pufferposition bezogen auf ihre horizontale Anordnung zwischen der Zuführeinheit (6) und/oder der Wegführeinheit (7) einerseits und der ersten Übergabeposition und/oder der zweiten Übergabeposition andererseits vorgesehen ist.

9. Bondanordnung nach einem der Ansprüche 5 bis 8, **dadurch gekennzeichnet, dass** die erste Pufferposition und/oder die zweite Pufferposition und/oder die erste Übergabeposition und/oder die zweite Übergabeposition in einem Maschinengehäuse (12) des Bonders (1, 2, 3, 4, 5) vorgesehen ist.

10. Bondanordnung nach einem der Ansprüche 5 bis 9, **dadurch gekennzeichnet, dass** die Zuführeinheit (6) und/oder die Wegführeinheit (7) dem Bonder (1, 2, 3, 4, 5) auf einer Rückseite (8) zugeordnet sind und/oder übereinander angeordnet sind.

11. Bondanordnung nach einem der Ansprüche 5 bis 10, **dadurch gekennzeichnet, dass** die Bondanordnung ausgebildet ist zum Durchführen des Verfahrens nach einem der Ansprüche 1 bis 4.

12. Bondanordnung nach einem der Ansprüche 5 bis 11, **dadurch gekennzeichnet, dass** die Vertikalfördereinheit (20) eine vertikal erstreckte Führungsschiene (23) und einen an der Führungsschiene (23) verschiebbar gehaltenen Tragekörper (24) aufweist.

13. Bondanordnung nach einem der Ansprüche 5 bis 12, **dadurch gekennzeichnet, dass** die erste Querfördereinheit (21) und/oder die zweite Querfördereinheit (22) Schlitten (25, 26) aufweisen, welche horizontal verschiebbar gehalten und von der ersten Pufferposition in die erste Übergabeposition und/oder von der zweiten Pufferposition in die zweite Übergabeposition verbringbar sind.

14. Bondanordnung nach einem der Ansprüche 5 bis 13, **dadurch gekennzeichnet, dass** mindestens zwei Bonder (1, 2, 3, 4, 5) vorgesehen sind, welche mit zwei einander zugewandten Querseiten ihrer Maschinengehäuse (12) aneinander gestellt sind, und dass den Bondern (1, 2, 3, 4, 5) eine gemeinsame Zuführeinheit (6) und/oder eine gemeinsame Wegführeinheit (7) zugeordnet sind.

15. Verwendung der Bondanordnung nach einem der Ansprüche 5 bis 14 zur Durchführung eines Verfahrens nach einem der Ansprüche 1 bis 4.

## Claims

1. Method for bonding large modules (30, 31, 33), **characterised by** the following steps:
- a large module (30, 31, 33) is fed to a bonder (1, 2, 3, 4, 5) from behind in a loading plane (27) by means of a feed unit (6);
- the large module (30, 31, 33) is handed over from the feed unit to a first transverse conveyor unit (21) and transferred by said unit into a first buffer position provided in the bonder (1, 2, 3, 4, 5), the first buffer position being provided in a loading plane (27) of the bonder (1, 2, 3, 4, 5);
- the large module (30, 31, 33) is transferred from the first buffer position into a first handover position, where it is handed over to a vertical conveyor unit (20), in the loading plane (27) by means of the first transverse conveyor unit (21);
- by means of the vertical conveyor unit (20), the large module (30, 31, 33) is displaced vertically and transferred into a bonding plane (29), the large module (30, 31, 33), in the bonding plane (29), being located at least in portions in a working region of the bonder (1, 2, 3, 4, 5);
- the large module (30, 31, 33) is processed by a first bonding head (15, 19) and optionally additionally by a second bonding head (15, 19), electrically conductive bonding connections being produced at the module (30, 31, 33);
- the large module (30, 31, 33) is displaced vertically out of the bonding plane (29) into a second handover position by the vertical conveyor unit (20), and in the second handover position handed over to a second transverse conveyor unit (22), the second handover position being provided in an unloading plane (28) of the bonder (1, 2, 3, 4, 5);
- the large module (30, 31, 33) in the unloading plane (28) is transferred into a second buffer position by the second transverse conveyor unit (22);
- the large module (30, 31, 33) is handed over to a removal unit (7) from the second buffer position by means of the second transverse conveyor unit (22).

2. Method according to claim 1, **characterised in that** the vertical conveyor unit (20) has a vertically displaceable carrier body (24) configured for receiving the module (30, 31, 33), the carrier body (24) being lowered below the loading plane (27) before the module (30, 31, 33) is transferred from the first buffer position into the handover position.

3. Method according to either claim 1 or claim 2, **characterised in that**, during the transferral of the module (30, 31, 33) from the first handover position into the bonding plane (29), the second handover position for the module (30, 31, 33) is passed over and/or the second conveyor unit (22) is provided in the second buffer position.

4. Method according to any of claims 1 to 3, **characterised in that** the carrier body (24) is displaced vertically out of the bonding plane (29) and lowered below the loading plane (27), and **in that**, during this lowering of the carrier body (24), the module (30, 31, 33) is handed over to the second transverse conveyor unit (22) while the second handover position is passed over.

5. Bonding arrangement comprising a bonder (1, 2, 3, 4, 5), comprising a supply unit (6) for a large module (30, 31, 33) which can be processed by means of the bonder (1, 2, 3, 4, 5), and comprising a removal unit (7) for the large module (30, 31, 33), the bonder (1, 2, 3, 4, 5) comprising at least one bonding head (15, 17, 19) by means of which electrically conductive bonding connections can be produced at the large module (30, 31, 33) during the processing of the large module (30, 31, 33), **characterised by** the following features:
- the bonder (1, 2, 3, 4, 5) comprises a vertical conveyor unit (20), which is configured for vertically conveying the large module (30, 31, 33) from a loading plane (27) into a bonding plane (29) and/or into an unloading plane (28);
- the bonder (1, 2, 3, 4, 5) further comprises a first transverse conveyor unit (21), which is assigned to the loading plane (27) and is configured to receive the large module (30, 31, 33) from the supply unit (6), to transfer the module (30, 31, 33) into a first buffer position provided in the loading plane (27), and to transfer the large module (30, 31, 33) into a first handover position, in which the large module (30, 31, 33) is prepared for handover to the vertical conveyor unit (20);
- the bonder (1, 2, 3, 4, 5) preferably comprises a second transverse conveyor unit (22), which is assigned to the unloading plane (28) and is configured to accept the large module (30, 31, 33) from the vertical conveyor unit (20) in a second handover position, to transfer the large module (30, 31, 33) into a second buffer position, the second handover position and the second buffer position being provided in the unloading plane (28), and to hand over the large module (30, 31, 33) to the removal unit (7), which is likewise assigned to the unloading plane (28).

6. Bonding arrangement according to claim 5, **characterised in that** the bonding plane (29) is provided above the loading plane (27) and/or above the unloading plane (28).

7. Bonding arrangement according to either claim 5 or claim 6, **characterised in that** the unloading plane (28) is provided above the loading plane (27).

8. Bonding arrangement according to any of claims 5 to 7, **characterised in that** the first buffer position and/or the second buffer position, in terms of the horizontal arrangement thereof, are provided between the supply unit (6) and/or removal unit (7) on the one hand and the first handover position and/or second handover position on the other hand.

9. Bonding arrangement according to any of claims 5 to 8, **characterised in that** the first buffer position and/or second buffer position and/or first handover position and/or second handover position are provided in a machine housing (12) of the bonder (1, 2, 3, 4, 5).

10. Bonding arrangement according to any of claims 5 to 9, **characterised in that** the supply unit (6) and/or the removal unit (7) are assigned to the bonder (1, 2, 3, 4, 5) on a rear face (8) and/or are arranged above one another.

11. Bonding arrangement according to any of claims 5 to 10, **characterised in that** the bonding arrangement is configured to carry out the method according to any of claims 1 to 4.

12. Bonding arrangement according to any of claims 5 to 11, **characterised in that** the vertical conveyor unit (20) has a vertically extending guide rail (23) and a carrier body (24) which is held displaceably on the guide rail (23).

13. Bonding arrangement according to any of claims 5 to 12, **characterised in that** the first transverse conveyor unit (21) and/or the second transverse conveyor unit (22) have slides (25, 26), which are held horizontally displaceably and are transferrable from the first buffer position into the handover position and/or from the second buffer position into the second handover position.

14. Bonding arrangement according to any of claims 5 to 13, **characterised in that** at least two bonders (1, 2, 3, 4, 5) are provided, two mutually facing transverse faces of the machine housings (12) thereof being placed against one another, and **in that** a joint feed unit (6) and/or a joint removal unit (7) are assigned to the bonders (1, 2, 3, 4, 5).

15. Use of the bonding arrangement according to any of claims 5 to 14 to carry out a method according to any of claims 1 to 4.

## Revendications

1. Procédé de soudage de modules de grande taille (30, 31, 33) **caractérisé par** les étapes suivantes :
- un module de grande taille (30, 31, 33) est amené par l'arrière à une soudeuse (1, 2, 3, 4, 5) au moyen d'une unité d'alimentation (6) dans un plan de chargement (27) ;
- le module de grande taille (30, 31, 33) est transféré depuis l'unité d'alimentation sur une première unité de convoyage transversal (21) et est passé depuis celle-ci vers une première position tampon prévue dans la soudeuse (1, 2, 3, 4, 5), dans lequel la première position tampon est prévue dans un plan de chargement (27) de la soudeuse (1, 2, 3, 4, 5) ;
- le module de grande taille (30, 31, 33) est, au moyen de la première unité de convoyage transversal (21), passé de la première position tampon vers une première position de reprise dans le plan de chargement (27) et, de là, est transféré sur une unité de convoyage vertical (20) ;
- le module de grande taille (30, 31, 33) est, au moyen de l'unité de convoyage vertical (20), déplacé verticalement et passé vers un plan de soudage (29), dans lequel le module de grande taille (30, 31, 33) dans le plan de soudage (29) se trouve par sections dans une zone de travail de la soudeuse (1, 2, 3, 4, 5) dans tous les cas ;
- le module de grande taille (30, 31, 33) est traité par une première tête de soudage (15, 19) et, en outre, facultativement par une deuxième tête de soudage (15, 19), dans lequel des joints soudés électriquement conducteurs sont produits sur le module (30, 31, 33) ;
- le module de grande taille (30, 31, 33) est déplacé verticalement hors du plan de soudage (29) depuis l'unité de convoyage vertical (20) vers une deuxième position de transfert et est transféré, dans la deuxième position de transfert, sur une deuxième unité de convoyage transversal (22), dans lequel la deuxième position de transfert est prévue dans un plan de déchargement (28) de la soudeuse (1, 2, 3, 4, 5) ;
- le module de grande taille (30, 31, 33) est passé depuis la deuxième unité de convoyage transversal (22) vers une deuxième position tampon dans le plan de déchargement (28) ;
- le module de grande taille (30, 31, 33) est transféré, au moyen de la deuxième unité de convoyage transversal (22), depuis la deuxième position tampon sur une unité d'enlèvement (7).

2. Procédé selon la revendication 1, **caractérisé en ce que** l'unité de convoyage vertical (20) comporte un corps porteur (24) coulissant verticalement et réalisé pour accueillir le module (30, 31, 33), dans lequel le corps porteur (24) est, avant le passage du module (30, 31, 33) depuis la première position tampon vers la position de transfert, abaissé sous le plan de chargement (27).

3. Procédé selon la revendication 1 ou 2, **caractérisé en ce que** lorsque le module (30, 31, 33) est passé vers le plan de soudage (29) depuis la première position de transfert, la deuxième position de transfert pour le module (30, 31, 33) est franchie et/ou la deuxième unité de convoyage transversal (22) est prévue dans la deuxième position tampon.

4. Procédé selon l'une des revendications 1 à 3, **caractérisé en ce que** le corps porteur (24) est déplacé verticalement hors du plan de soudage (29) et abaissé sous le plan de chargement (27) et **en ce que** lors de cet abaissement du corps porteur (24) le module (30, 31, 33) est transféré à la deuxième unité de convoyage transversal (22) pendant que la deuxième position de transfert est franchie.

5. Système de soudage avec une soudeuse (1, 2, 3, 4, 5) dotée d'une unité d'alimentation (6) pour un module de grande taille (30, 31, 33), lequel peut être traité au moyen de la soudeuse (1, 2, 3, 4, 5), et dotée d'une unité d'enlèvement (7) pour le module de grande taille (30, 31, 33), dans lequel la soudeuse (1, 2, 3, 4, 5) comprend au moins une tête de soudage (15, 17, 19), au moyen de laquelle des connexions soudées électriquement conductrices peuvent être produites sur le module de grande taille (30, 31, 33) lors du traitement du module de grande taille (30, 31, 33), **caractérisé par** les points suivants :
- la soudeuse (1, 2, 3, 4, 5) comprend une unité de convoyage vertical (20), laquelle est réalisée pour convoyer verticalement le module de grande taille (30, 31, 33) depuis un plan de chargement (27) vers un plan de soudure (29) et/ou vers un plan de déchargement (28) ;
- la soudeuse (1, 2, 3, 4, 5) comprend en outre une première unité de convoyage transversal (21), laquelle est associée au plan de chargement (27) et est réalisée pour accueillir le module de grande taille (30, 31, 33) depuis l'unité d'alimentation (6), pour le passage du module (30, 31, 33) vers une première position tampon prévue dans le plan de chargement (27) et pour le passage du module de grande taille (30, 31, 33) vers une première position de transfert, où le module de grande taille (30, 31, 33) est préparé pour le transfert sur l'unité de convoyage vertical (20) ;
- la soudeuse (1, 2, 3, 4, 5) comprend de préférence une deuxième unité de convoyage transversal (21), laquelle est associée au plan de déchargement (28) et est réalisée pour reprendre le module de grande taille (30, 31, 33) depuis l'unité de convoyage vertical (20) dans une deuxième position de transfert, pour le passage du module de grande taille (30, 31, 33) vers une deuxième position de transfert, dans lequel la deuxième position de transfert et la deuxième position tampon sont prévues dans le plan de déchargement (28), et pour le transfert du module de grande taille (30, 31, 33) à l'unité d'enlèvement (7) associée également au plan de déchargement (28).

6. Système de soudage selon la revendication 5, **caractérisé en ce que** le plan de soudage (29) est prévu au-dessus du plan de chargement (27) et/ou au-dessus du plan de déchargement (28).

7. Système de soudage selon la revendication 5 ou 6, **caractérisé en ce que** le plan de déchargement (28) est prévu au-dessus du plan de chargement (27).

8. Système de soudage selon l'une des revendications 5 à 7, **caractérisé en ce que** la première position tampon et/ou la deuxième position tampon est prévue, par rapport à sa disposition horizontale, entre l'unité d'alimentation (6) et/ou l'unité d'enlèvement (7) d'un côté et la première position de transfert et/ou la deuxième position de transfert de l'autre côté.

9. Système de soudage selon l'une des revendications 5 à 8, **caractérisé en ce que** la première position tampon et/ou la deuxième position tampon et/ou la première position de transfert et/ou la deuxième position de transfert est prévue dans un boîtier de machine (12) de la soudeuse (1, 2, 3, 4, 5).

10. Système de soudage selon l'une des revendications 5 à 9, **caractérisé en ce que** l'unité d'alimentation (6) et/ou l'unité d'enlèvement (7) sont associées à la soudeuse (1, 2, 3, 4, 5) sur une face arrière (8) et/ou sont disposées l'une au-dessus de l'autre.

11. Système de soudage selon l'une des revendications 5 à 10, **caractérisé en ce que** le système de soudage est réalisé pour mettre en œuvre le procédé selon l'une des revendications 1 à 4.

12. Système de soudage selon l'une des revendications 5 à 11, **caractérisé en ce que** l'unité de convoyage vertical (20) comporte un rail de guidage (23) s'étendant verticalement et un corps porteur (24) maintenu de manière coulissante sur le rail de guidage (23).

13. Système de soudage selon l'une des revendications 5 à 12, **caractérisé en ce que** la première unité de convoyage (21) et/ou la deuxième unité de convoyage (22) comportent des chariots (25, 26), lesquels sont maintenus de manière horizontalement coulissante et peuvent passer depuis la première position tampon vers la première position de transfert et/ou depuis la deuxième position tampon vers la deuxième position de transfert.

14. Système de soudage selon l'une des revendications 5 à 13, **caractérisé en ce qu'**au moins deux soudeuses (1, 2, 3, 4, 5) sont prévues, lesquelles sont placées l'une contre l'autre avec deux faces transversales, tournées l'une vers l'autre, de leurs boîtiers de machine (12), et **en ce qu'**une unité d'alimentation commune (6) et/ou une unité d'enlèvement commune (7) sont associées aux soudeuses (1, 2, 3, 4, 5).

15. Utilisation du système de soudage selon l'une des revendications 5 à 14 pour mettre en œuvre un procédé selon l'une des revendications 1 à 4.
